# EUROPÄISCHE PATENTANMELDUNG

(11) **EP 0 877 541 A2**
(43) Veröffentlichungstag der Anmeldung: **11.11.1998**
(21) Anmeldenummer: 98104531.3
(22) Anmeldetag: 01.04.1998
(51) Int. Cl.: H05K 5/00

(54) **Gehäuse für hochfrequent lärm- und wärmeemittierende Baugruppen**

(30) Priorität: 10.04.1997 DE 19714835
(71) Anmelder: Schlomka, Georg, 21640 Neuenkirchen (DE)
(72) Erfinder: Schlomka, Georg, 21640 Neuenkirchen (DE)
(74) Vertreter: Seemann, Ralph, Dr. Dipl.-Phys.

(57) **Zusammenfassung**

Die vorliegende Erfindung betrifft ein wärmeabführendes und schalldämmendes Gehäuse (1, 2; 11, 12) für eine schall- und wärmeemittierende Einheit (5), wobei das Gehäuse (1, 2; 11, 12)
- wenigstens eine aus wärmeleitendem und festem Material bestehende Gehäuseseitenfläche, dessen innere Fläche zu der Einheit (5) beabstandet ist,
- ein in dem durch den Abstand definierten Raum angeordnetes fließfähiges Stoffsystem (7), insbesondere einer Flüssigkeit, die in thermischem Kontakt zu der bzw. den Gehäuseseitenflächen und der Einheit (5) steht, und
- eine Folie (9), die wenigstens zwischen einem Teil der Einheit (5) und dem fließfähigen Stoffsystem (7) angeordnet ist, aufweist.
Die Erfindung zeichnet sich dadurch aus, daß der thermische Kontakt zur Gehäuseseitenfläche ausschließlich durch Benetzung des Gehäuses (1,2; 11, 12) mit dem fließfähigen Stoffsystem (7) oder über die oder eine weitere Folie (9) erfolgt und daß die Einheit (5) an wenigstens einer Seite von dem fließfähigen Stoffsystem (7) umgeben ist.

## Beschreibung

Die Erfindung betrifft ein wärmeabführendes und schalldämmendes Gehäuse für eine schall- und wärmeemittierende Einheit gemäß dem Oberbegriff des Patentanspruchs 1.

Derartige Gehäuse sind aus der US-PS-5 510 954 bekannt.

Insbesondere Festplatten emittieren Lärm besonders im hochfrequenten Bereich, der durch ein Pfeifen einer Spindellagerbewegung und Luftpfeifgeräusche durch Drehen der Magnetplatten im Inneren der Festplattengehäuse hervorgerufen wird. Hinzu kommen unregelmäßige Geräusche beim Zugriff auf Daten der Festplatte, die als impulsartige, schnell aufeinanderfolgende Geräuschspitzen auftreten. Die Spitzen an sich sind hochfrequent und die schnelle Abfolge des Zugriffs selbst erzeugt ein tieffrequentes Geräusch. Bei modernen Festplatten erreicht das Geräuschniveau bis zu 52 dBA im Ruhebetrieb bzw. 57 dBA beim Zugriff. Hiergegen stehen die Werte von höchstens 48 dBA Ruhebetriebsgeräusch, die empfohlen werden.

Zudem sind die moderneren Festplatten meistens kühlungsbedürftig, da deren Leistungsaufnahme bei über 20 Watt liegen kann, die im wesentlichen durch die üblicherweise außen angebrachten Bauelemente verbraucht werden. Aufgrund der geringen Wärmekapazitat der außen auf der Festplatte angeordneten Bauelemente erwärmen sich diese bzw. kühlen sich diese sehr schnell ab, sofern keine entsprechenden Maßnahmen vorgesehen sind, die diese Vorgänge verlangsamen. D.h. es kommt zu einer schnelleren Alterung der Bauelemente aufgrund häufig vorkommender thermischer Spannungen.

Zudem ist es vorteilhaft, wenn die Festplatte relativ weich gelagert ist, um etwaige Stöße, die auf diese ausgeübt werden, abzufangen.

Um eine entsprechende Festplatte im Betrieb derart anzuordnen bzw. zu lagern, daß diese zum einen wenig Geräusche nach außen abgeben kann und zum anderen die Lebensdauer des Festplatte erhöht wird, kommt es also im wesentlichen auf vier Parameter an:
1. Reduktion insbesondere der hochfrequenten Geräusche,
2. ausreichende Kühlung der wärmeemittierenden Bauelemente,
3. Verringerung der Steigung der Temperatur pro Zeiteinheit gesehen beim Erwärmen und Abkühlen der Bauelemente und
4. relativ weiche Lagerung, um Stöße abzufangen.

Aus der US-PS-5 510 954 ist lediglich bekannt, daß eine entsprechende Festplatte gekühlt werden muß, um deren Lebensdauer zu erhöhen, und daß entsprechende Mittel vorgesehen sein müssen, die Geräusche der Festplatte mindern. Hierzu wird ein relativ komplex aufgebautes Gehäuse vorgeschlagen, das aus einem Acrylmaterial besteht und bei dem außerhalb der Gehäusewand aus Acrylmaterial ein Kühlkörper angeordnet ist. Von diesem Kühlkörper ausgehend ist ein wärmeleitfähiges Material wie beispielsweise Kupfer in Form einer Leitung zu einer metallischen Klammer angeordnet. Die Kupferleitung überbrückt die Distanz durch mehrere Schichten schalldämmenden Materials, die nach der US-PS-5 510 954 notwendig sind, um den Lärm der Festplatte entsprechend zu dämmen.

Innerhalb der metallischen Klammer ist ein Beutel angeordnet, der mit einer Flüssigkeit gefüllt ist. Dieser mit Flüssigkeit gefüllte Beutel wird benutzt, um einerseits als Kühlung zu fungieren und andererseits sowohl Geräusche zu mindern als auch Stöße von der Festplatte fernzuhalten.

Die Vorrichtung gemäß der US-PS-5 510 954 hat den Nachteil, daß es aufgrund dessen, daß an drei Seiten keine Wärme abgenommen wird, zu einen Hitzestau kommen kann. Außerdem führt die Abführung der Wärme mittels eines Kabels und eines Kühlkörpers lediglich zu einer punktuellen Abfuhr von Wärme, was zu einer ungleichmäßigen Kühlung der Festplatte führt. Desweiteren wird ein sehr großes und komplexes Gehäuse mit entsprechend großen Mengen an Dämmaterial benötigt, um entsprechend Schall zu absorbieren.

Es ist demnach Aufgabe der vorliegenden Erfindung, ein Gehäuse anzugeben, das bei relativ kompakter Bauart eine ausreichende Schalldämmung und eine verbesserte Kühlung der wärmeemittierenden Bauelemente einer Einheit ermöglicht, wobei dabei die Geschwindigkeit der Erwärmung bzw. Abkühlung der sich erwärmenden Bauelemente verringert wird und gleichzeitig eine gewisse Stoßsicherung der schall- und wärmeemittierenden Einheit erreicht wird.

Gelöst wird diese Aufgabe durch die Merkmale des Patentanspruchs 1.

Erfindungsgemäß ist ein wärmeabführendes und schalldämmendes Gehäuse für eine schall- und wärmemittierende Einheit vorgesehen, wobei das Gehäuse die folgenden Merkmale aufweist:
- wenigstens eine aus wärmeleitendem und festem Material bestehende Gehäuseseitenfläche, dessen innere Fläche zu der Einheit beabstandet ist,
- ein in dem durch den Abstand definierten Raum angeordnete fließfähiges Stoffsystem, insbesondere eine Flüssigkeit, die in thermischem Kontakt zu der bzw. den Gehäuseseitenflächen und der Einheit steht, und
- eine Folie, die wenigstens zwischen einem Teil der Einheit und dem fließfähigen Stoffsystem angeordnet ist, wobei der thermische Kontakt zur Gehäuseseitenfläche ausschließlich durch Benetzung des Gehäuses mit dem fließfähigen Stoffsystem oder über die oder eine weitere Folie erfolgt, und wobei die Einheit an wenigstens eine Seite von dem fließfähigen Stoffsystem umgeben ist.

Erfindungsgemäß ist nämlich erkannt worden, daß die aus der US-PS-5 510 954 offenbarten weiteren Merkmale, nämlich insbesondere die weiteren Dämmaterialien und der metallischen Klammer, die mittels eines wärmeleitenden Kabels mit einem Kühlkörper verbunden ist, dann vermieden werden können, wenn der thermische Kontakt zur Gehäuseseitenfläche ausschließlich durch Benetzung des Gehäuses mit dem fließfähigen Stoffsystem oder über die oder eine weitere Folie erfolgt, und wenn die Einheit an wenigstens einer Seite von dem fließfähigen Stoffsystem umgeben ist, so daß ein ausreichender Wärmetransport zu der Außenfläche des Gehäuses stattfinden kann.

Vorzugsweise sind alle inneren Flächen des Gehäuses von der Einheit beabstandet. Der Abstand beträgt vorzugsweise zwischen 5 und 20 mm und insbesondere im wesentlichen 7 mm. Durch diese Maßnahme können in alle Zwischenräume entsprechende Dämmittel eingeführt werden.

Eine besonderes einfache Bauweise bzw. Montage ergibt sich, wenn das Gehäuse vorzugsweise wenigstens zweiteilig ist.

Eine entsprechend gute Geräuschdämmung bzw. Staubdichtigkeit ergibt sich vorteilhafterweise dann, wenn nach Verschließen des Gehäuses bis auf Öffnungen für Zuleitungen dieses im wesentlichen dicht ist. Weiter vorteilhafterweise ist an einer oder an mehreren weiteren Seiten der Einheit Dämmaterial , insbesondere ein fließfähiges Stoffsystem, angeordnet, wobei zwischen Einheit und Stoffsystem eine Folie angeordnet ist.

Besonders vorzugsweise umschließt die Flüssigkeit die schall- und wärmeemittierende Einheit lückenlos. Wenn vorzugsweise die Folie an den Gehäuseseitenflächen derart abgedichtet ist, daß kein Stoff des fließfähigen Stoffsystems zu der Einheit gelangen kann, kann zum einen relativ wenig Folienmaterial Verwendung finden und zum anderen ein noch verbesserter thermischer Kontakt zwischen fließfähigem Stoffsystem und Gehäuseseitenflächen hergestellt werden.

Eine erhöhte Wärmeleitung und eine Verlängerung der Folienlebensdauer wird vorzugsweise dadurch erreicht, daß die Folie der Form der Einheit entsprechend vorgeformt ist.

Ein besonders einfach herzustellendes Gehäuse bzw. Dämmittel ergibt sich dann, wenn vorzugsweise die Folie bzw. die Folie mit der weiteren Folie ein beutelförmiges Gebilde ist. Auf diese Weise können beispielsweise aus dem Pharmabereich an sich bekannte Kühlkompressen Verwendung finden, die entsprechend in die Gehäuseteile eingelegt werden. Hersteller derartiger Kompressen sind beispielsweise Scotch 3M, Pino GmbH und Wena GmbH.

Eine besonders vorzugsweise Ausgestaltung ergibt sich, wenn die Folie bzw. die Folien ein Schlauch ist bzw. sind, in den die Einheit einführbar ist, so daß der Schlauch wenigstens eine Umrandungsfläche der Querschnitte der Einheit umschließt, die parallel zueinander sind. Bei einer Festplatte bedeutet dies, daß wenigstens vier Seiten der Einheit umschlossen sind. Durch diese Maßnahme ergeben sich weniger Dichtigkeitsprobleme.

Weiter vorzugsweise weist das fließfähige Stoffsystem eine derartige Viskosität auf, daß alleine aufgrund der Temperaturverhältnisse um die Einheit eine die Hitze abführende Wirkung des fließfähigen Stoffsystems erhöhende Konvektion stattfindet. Diese hitzeabführende Wirkung ist besonders dann effektiv, wenn vorzugsweise die Konvektion über einen Kreislauf erfolgt, der über den gesamten Querschnitt des sich im Schlauch bzw. zwischen Schlauch und Gehäuse befindlichen fließfähigen Stoffsystems erfolgt.

Vorteilhafterweise behalten die Folien bzw. Folien in einem Bereich von - 30 °C bis 120 °C ihre Eigenschaften im wesentlichen bei. Die Folie bzw. Folien bestehen dabei vorzugsweise aus einem reißfesten, wärmeleitenden und dehnbaren Kunststoff, Gummi bzw. Elastomer.

Der Wärmekontakt und damit die Möglichkeit des Abführens der Wärme wird dadurch erhöht, daß vorzugsweise Mittel vorgesehen sind, die ein Andrücken der Folie an wenigstens die warmen bzw. heißen Flächen der Einheit und/oder wenigstens eine Innenfläche des Gehäuses ermöglichen. Besonders bevorzugt ist es, wenn ein Druck im fließfähigen Stoffsystem aufgebaut werden kann, mittels dem eine möglichst flexible Folie derart an die Bauelemente auf beispielsweise einer Festplatte angedrückt wird, daß möglichst wenig Luftspalten bzw. gar keine Luftspalten zwischen den sehr heißen Elementen und der Folie entstehen. Auf diese Art und Weise findet ein guter Wärmekontakt statt. Ferner wird vorzugsweise ein Unterdruck im fließfähigen Stoffsystem erzeugt, so daß zum Einführen einer Einheit mehr Platz geschaffen werden kann.

Diese Mittel umfassen vorzugsweise eine verschließbare Öffnung und/oder ein Ventil, durch die unter Druck ein fließfähiges Stoffsystem eingeführt und/oder herausgelassen werden kann.

Ferner umfassen die Mittel vorzugsweise ein Druckmittel, mit dem eine Kraft auf wenigstens eine flexible Außenfläche des Gehäuses bzw. auf relativ zueinander bewegliche Teile des Gehäuses ausübbar ist.

Wenn vorzugsweise das Gehäuse derart anzuordnen ist, daß die Seite der Einheit, die die warmen bzw. heißen Flächen aufweist, im wesentlichen vertikal angeordnet ist, sind keine weiteren Mittel nötig, um eine Bewegung des fließfähigen Stoffsystems zu erreichen. Vorzugsweise ist diese Anordnung in einem Winkelbereich von - 30 °C bis 30 °C von der Vertikalen.

Vorzugsweise wird zur weiteren Verringerung der Schallemission das Gehäuse mittels endlosen bzw. quasi endlosen und/oder länglichen Elastomeren befestigt. Auf diese Art und Weise wird insbesondere niederfrequenter Schall gedämmt und zudem werden Stöße, die auf die Festplatte wirken könnten, gedämpft. Hierzu wird insbesondere Bezug auf die Patentanmeldung DE 197 11 079 genommen, deren Offenbarung in dieser Anmeldung enthalten sein soll. Insbesondere wird auch auf die verbesserten Ausführungsformen aus der Patentanmeldung DE 197 11 079 Bezug genommen.

Eine entsprechend gute Wärmeabführung vom Gehäuse findet dann statt, wenn vorzugsweise das Gehäuse aus einem wärmeleitfähigen Material, insbesondere Metall besteht und/oder die Oberfläche des Gehäuses im Vergleich zu einer flachen Fläche erhöht ist. Insbesondere ist es vorteilhaft, wenn die Oberfläche gewellt ist.

Vorzugsweise ist ein Computer mit wenigstens einem für in dem Computer angeordneten schall- und wärmeemittierenden Einheiten vorgesehenen Gehäuse ausgestattet.

Die vorliegende Erfindung ist nicht auf Computer und darin befindliche Festplatten bzw. andere Computereinheiten, die Schall und Wärme emittieren, beschränkt. Vielmehr können auch andere schall- und wärmeemittierende Einheiten entsprechend mit einem Gehäuse versehen werden, das die erfindungsgemäßen Eigenschaften aufweist. Hierbei ist insbesondere an beispielsweise Pumpen, Elektromotoren und Getriebe gedacht.

Im Rahmen dieser Erfindung bedeutet Computer auch Mikrocomputer, Personalcomputer, Workstation, Arbeitsplatzcomputer, Computeranlage, Rechenanlage, Nachrichtenverarbeitungsmaschine, Rechner, Datenverarbeitungsmaschine, EDV-Anlage usw..

Unter fließfähigem Stoffsystem ist auch eine geleeartige Masse gemeint und auch ein System bestehend aus Kügelchen, die insbesondere von einer Paste umgeben sind.

Die Erfindung wird nachstehend ohne Beschränkung des allgemeinen Erfindungsgedankens anhand von Ausführungsbeispielen unter Bezugnahme auf die Zeichnung exemplarisch beschrieben, auf die im übrigen bezüglich der Offenbarung aller im Text nicht näher erläuterten erfindungsgemäßen Einzelheiten ausdrücklich verwiesen wird. Es zeigen
- Fig. 1: eine erfindungsgemäße Ausführungsform in dreidimensionaler Darstellung,
- Fig. 2: die Ausführungsform aus Fig. 1 in Seitenansicht und entlang eines Schnitts,
- Fig. 3: die Ausführungsform aus Fig. 1 und 2 von einer anderen Seite im Schnitt gesehen,
- Fig. 4: eine weitere Ausführungsform in dreidimensionaler Ansicht und im Schnitt und
- Fig. 5: die Ausführungsform aus Fig. 4 von einer anderen Seite im Schnitt betrachtet.

In den folgenden Figuren sind jeweils gleiche oder entsprechende Teile mit denselben Bezugszeichen bezeichnet, so daß auf eine erneute Vorstellung verzichtet wird und lediglich die Abweichungen der in diesen Figuren dargestellten Ausführungsbeispielen gegenüber dem ersten Ausführungsbeispiel erläutert werden:

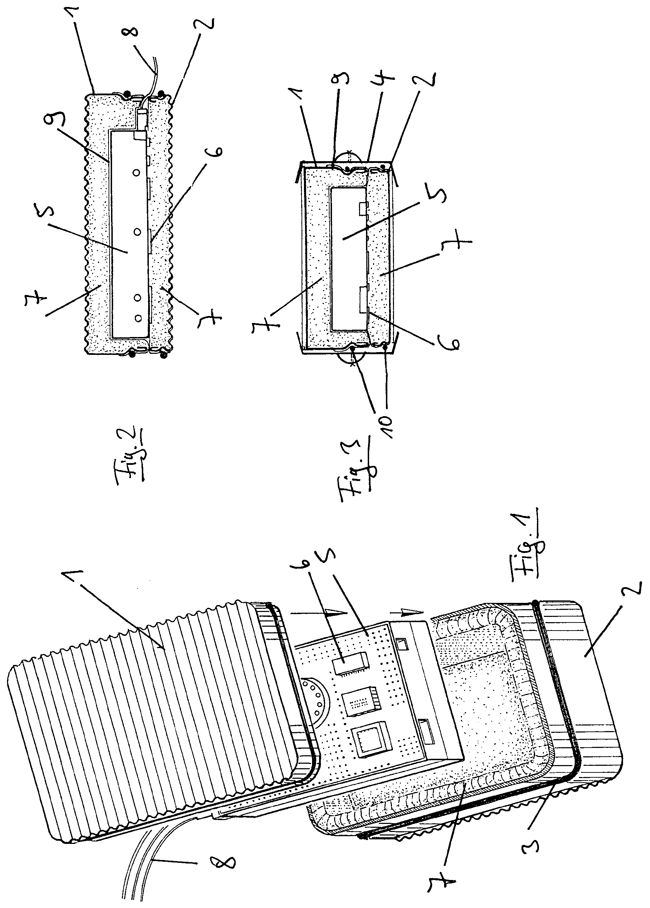

In Fig. 1 ist eine erste erfindungsgemäße Ausführungsform dargestellt, bei der die entsprechenden Teile noch nicht zusammengefügt sind.

Ein Gehäusedeckel 1 ist passend mit einem Gehäuseboden 2 angefertigt. Der Gehäusedeckel 1 und der Gehäuseboden 2 weisen jeweils eine Oberfläche auf, die gewellt ist, um eine erhöhte Oberfläche im Vergleich zu einer flachen Fläche zu erreichen, wodurch eine größere Wärmeabstrahlung erfolgt. In dem Gehäuseboden und auch in dem Gehäusedeckel, die vorzugsweise aus einem Metall Wie Aluminium bestehen, ist eine Kühlflüssigkeit 7 angeordnet, die vom Auslaufen über Folien 9 geschützt ist.

Anstelle des vollausgekleideten Gehäusedeckels und entsprechend des Gehäusebodens, die zusammen das Gehäuse darstellen, können auch entsprechende Beutel verwendet werden, die mit einer Kühlflüssigkeit 7 gefüllt sind und die in den Gehäusedeckel und den Gehäuseboden eingelegt bzw. eingeklebt sind, so daß in diesem Beispiel sämtliche Innenflächen des Gehäuses mit einer entsprechender Schicht bedeckt sind. In das Gehäuse eingebracht werden soll eine Festplatte 5, die sich erwärmende bzw. heiße Bauelemente 6 in unebener Anordnung aufweist und mittels Kabel 8 mit Strom und Daten versorgt wird. Zum Verschließen des Gehäuses wird die Festplatte 5 in den Gehäuseboden 2 hineingelegt und der Deckel 1 gemäß den angedeuteten Pfeilen auf den Gehäuseboden gedrückt. Ein Verschließen kann über Dichtringe 3 oder über Rastmittel, die nicht gezeigt sind, stattfinden. Schließlich kann das Gehäuse mittels endlosen, quasiendlosen und/oder länglichen Elastomeren, die eine Befestigung im Computer ermöglichen, zusammengehalten bzw. sogar mittels eines gewünschten Anpressdrucks zusammengedrückt werden, um den gewünschten Druck in der Flüssigkeit zu erzeugen.

Wie in Fig. 3 dargestellt, kann ein Verschließen auch über eine Klammer bzw. zwei Klammern 4 stattfinden. In diesem Ausführungsbeispiel , das in den Figuren 1 bis 3 dargestellt ist, ist die Folie 9 bzw. sind die Folien 9 mittels Spannringen 10 derart an dem Gehäuse befestigt, daß keine sich in dem Zwischenraum zwischen Folie und Gehäuse befindliche Flüssigkeit entweichen kann. Alternativ hierzu könnte auch eine Verklebung zwischen Folien und Gehäuse stattfinden.

Die Flüssigkeit ist vorzugsweise eine schwere Flüssigkeit, wie beispielsweise Wasser oder Silikonöl und ist besonders bevorzugterweise nicht elektrisch leitend bzw. nicht aggressiv zu elektronischen Bauelementen. Hierzu eignen sich Fluorkohlenstoffe, die flüssig sind und sowohl chemisch als auch elektrisch inert, so daß bei einer Undichtigkeit der Folie bzw. der Verbindung der Folie zu den Gehäuseteilen keine Beschädigung der Festplatte bzw. der darauf befindlichen Bauelemente stattfindet.

Die Folie sollte die Festplatte möglichst stramm umschließen bzw. berühren. Die Flüssigkeit selber wird unter Druck gebracht, um ein Anschmiegen der Folie an die Festplatte und insbesondere den einzelnen heißen Bauelementen 6 zu ermöglichen. Durch diese Maßnahme wird eine gute Wärmeableitung von der Festplatte in die Flüssigkeit erreicht. Die Flüssigkeit selbst verteilt die Wärme dann durch Konduktion und je nach Wahl der Flüssigkeit auch Konvektion und führt die Wärme an die Außenseiten des Gehäuses ab. In diesem Fall, d.h. bei diesem Ausführungsbeispiel, wird die Wärme an die sechs Außenseiten des Gehäuses abgeführt. Dieses führt die Wärme an die umgebende Luft ab.

Bei diesem Ausführungsbeispiel ist die Festplatte vollständig von einer Flüssigkeitsschicht umgeben, die sich durch eine ausgeprägte Dämpfung von Geräuschen, insbesondere von hohen Frequenzen, auszeichnet. Ferner wird eine entsprechende Dämpfung von Schlägen bzw. Stößen und eine Kühlung der heißen Bauelemente ermöglicht und die Steigung der Temperatur über die Zeit nach dem Ein- bzw. Ausschalten der Festplatte und die Temperaturspitzen einzelner Bauelemente im Betrieb verringert. Das gesamte Gehäuse stellt damit eine geräuschgedämmte Einheit dar, die die im Inneren entstehende Wärme zum einen verteilt und zum anderen gleichmäßig über die im Verhältnis zur Baugruppe erheblich vergrößerten Außenoberfläche abgibt.

Die erreichten Vorteile liegen auf der Hand:
1. Es findet eine exzellente Geräuschdämmung von über 90 % statt,
2. die Temperaturspitzen einzelner Bauelemente werden deutlich abgesenkt, was die Lebensdauer dieser erhöht,
3. die Kühlleistung der gesamten Baugruppe wird durch eine Erhöhung der Außenoberflächen vergrößert, so daß auch Hochleistungsfestplatten noch bei hohen Temperaturen ohne zusätzlichen Lüfter betrieben werden können,
4. ein verzögerter Anstieg bzw. Abfall von Temperaturen wird durch die hohe Wärmekapazität der Flüssigkeit sowie die relativ große Menge bzw. Masse der Flüssigkeit erreicht und
5. es findet eine Dämpfung von Stößen auf die Einheit statt.

Durch den 2. Vorteil werden Alterungsprozesse im Dauerbetrieb vermindert.

Durch den 4. werden Alterungsprozesse durch das Ein- und Ausschalten der jeweils verwendeten Einheit vermindert. Zudem ist es möglich, die verwendete Baugruppe für eine begrenzte Zeit auch in Umgebungstemperaturen, die über den jeweils zulässigen Werten liegen, zu verwenden. Dieses ist insbesondere dann interessant, wenn beispielsweise ein Computer morgens bei recht geringen Temperaturen eingeschaltet wird und sich der Raum, in dem der Computer steht, beispielsweise im Sommer extrem aufheizt.

Weitere Vorteile ergeben sich dadurch, daß bestehende Rechner problemlos nachgerüstet werden können und sich eine weitgehende Staubdichtigkeit für die in das Gehäuse eingebrachten Elemente ergibt.

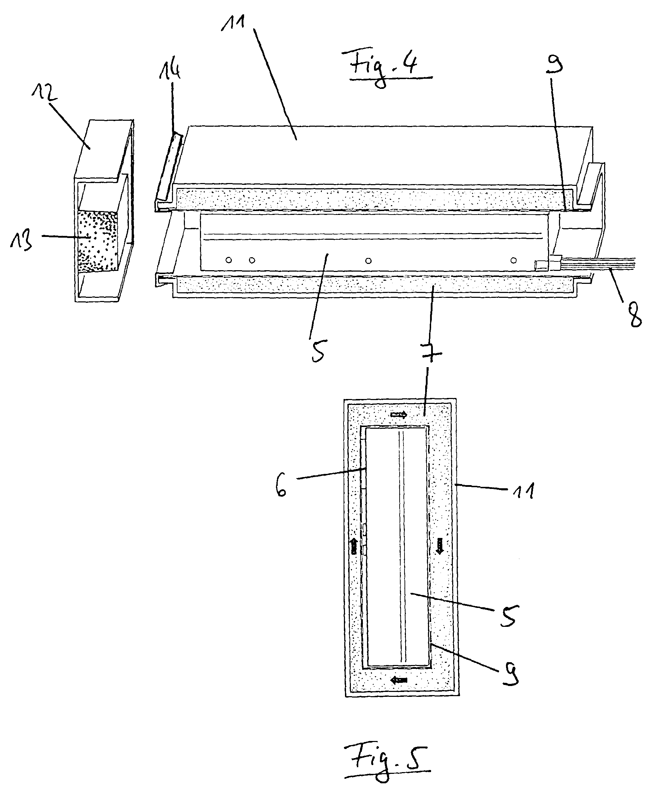

Eine zweite in den Figuren gezeigte Ausführungsform ist in den Figuren 4 und 5 dargestellt. Hierbei wird die Festplatte 5 in einen Schlauch geschoben, der durch die Folie 9 begrenzt ist. Die Flüssigkeit 7 befindet sich zwischen der Folie 9 und dem Gehäuse 11, so daß vier Seiten der Festplatte 5 durch die Flüssigkeit umschlossen sind. Bei dieser Ausführungsform ist die Flüssigkeit um vier Seiten der Festplatte in einem einzigen Raum angeordnet. Durch diese Maßnahme ist es möglich, eine großräumig Konvektion, die in Fig. 5 durch die Pfeile dargestellt ist, zu ermöglichen, mit der eine effektivere Wärmeabführung erreicht wird. Vorteilhafterweise wird das Gehäuse derart aufgestellt, daß sich die heißen Bauelemente 6 in einer Vertikalen befinden, so daß die Konvektion alleine durch das Temperaturgefälle zwischen der "heißen" Seite, in der Figur die linke Seite, und der anderen Seite der Festplatte, in der Figur die rechte Seite, die keine heißen Bauelemente 6 aufweist, stattfindet.

Um die Geräuschdämmung ausreichend effektiv zu gestalten, wird ein Deckel 12 mit üblichem Dämmaterial 13 bzw. mit Flüssigkeit gefüllten Beuteln wie ein Korken auf eine Flasche auf das Gehäuse 11 geschoben. Ein entsprechender Deckel kann in Fig. 4 auch auf der rechten Seite angebracht werden.

Die in den Figuren 4 und 5 dargestellte Ausführungsform beinhaltet ein dreiteiliges Gehäuse. Der Hauptteil des Gehäuses hat dabei eine Quaderform, wobei an den beiden Schmalseiten des Quaders ein Ausschnitt angebracht ist. Durch die Ausschnittsöffnungen wird die Festplatte ins Innere des Schlauches und des Gehäuses eingeschoben. Um die Festplatte leichter ein- und auszubauen zu können, können Mittel vorgesehen sein, mit denen in der Flüssigkeit 7 ein Unterdruck auf- und abgebaut werden kann. Bei einem Unterdruck wölbt sich die flexible Folie nach innen. Nach Einschieben der Festplatte wird unter Druck die Flüssigkeit wieder in den Raum zwischen Schlauch und Gehäuse eingeführt, so daß ein effektiver Wärmekontakt zwischen den heißen bzw. warmen Bauelementen und der Flüssigkeit erreicht werden kann. Die Dichtung zwischen Schlauch und Gehäuse findet u.a. mittels einer geeigneten Dichtschiene statt.

Vorzugsweise ist ein Druckausgleichmittel vorgesehen, mittels dem ein Druckausgleich dergestalt erreicht wird, das der Druck in der Flüssigkeit im wesentlichen stabil ist. Dazu könnte beispielsweise ein Ventil mit einem Auffangreservoir vorgesehen sein oder ein Druckausgleichsraum.

### Bezugszeichenliste

- 1: Gehäusedeckel
- 2: Gehäuseboden
- 3: Kante
- 4: Klammer
- 5: Festplatte
- 6: heißes Bauelement
- 7: Kühlflüssigkeit
- 8: Kabel
- 9: Folie
- 10: Spannring
- 11: Gehäuse
- 12: Deckel
- 13: Dämmaterial
- 14: Dichtschiene

## Patentansprüche

1. Wärmeabführendes und schalldämmendes Gehäuse (1, 2; 11, 12) für eine schall- und wärmeemittierende Einheit (5), wobei das Gehäuse (1, 2; 11, 12)
- wenigstens eine aus wärmeleitendem und festem Material bestehende Gehäuseseitenfläche, dessen innere Fläche zu der Einheit (5) beabstandet ist,
- ein in dem durch den Abstand definierten Raum angeordnetes fließfähiges Stoffsystem (7), insbesondere eine Flüssigkeit, die in thermischem Kontakt zu der bzw. den Gehäuseseitenflächen und der Einheit (5) steht, und
- eine Folie (9), die wenigstens zwischen einem Teil der Einheit (5) und dem fließfähigen Stoffsystem (7) angeordnet ist, aufweist,
dadurch gekennzeichnet, daß der thermische Kontakt zur Gehäuseseitenfläche ausschließlich durch Benetzung des Gehäuses (1, 2; 11, 12) mit dem fließfähigen Stoffsystem (7) oder über die oder eine weitere Folie (9) erfolgt und daß die Einheit (5) an wenigstens einer Seite von dem fließfähigen Stoffsystem (7) umgeben ist.

2. Gehäuse nach Anspruch 1, dadurch gekennzeichnet, daß alle innere Flachen des Gehäuses (1, 2; 11, 12) von der Einheit (5) beabstandet sind.

3. Gehäuse nach Anspruch 1 und/oder 2, dadurch gekennzeichnet, daß das Gehäuse (1, 2; 11, 12) wenigstens zweiteilig ist.

4. Gehäuse nach Anspruch 3, dadurch gekennzeichnet, daß das Gehäuse (1, 2; 11, 12) nach Verschließen bis auf Öffnungen für Zuleitungen (8) im wesentlichen dicht ist.

5. Gehäuse nach einem oder mehreren der Ansprüche 1 bis 4, dadurch gekennzeichnet, daß an einer oder mehrerer weiteren Seiten der Einheit Dämmaterial (13), insbesondere ein fließfähiges Stoffsystem (7) angeordnet ist, wobei zwischen Einheit (5) und Stoffsystem (7) eine Folie (9) angeordnet ist.

6. Gehäuse nach einem oder mehreren der Ansprüche 1 bis 5, dadurch gekennzeichnet, daß die Folie (9) an den Gehäuseseitenflächen derart abgedichtet ist, daß kein Stoff des fließfähigen Stoffsystems (7) zu der Einheit (5) gelangen kann.

7. Gehäuse nach einem oder mehreren der Ansprüche 1 bis 6, dadurch gekennzeichnet, daß die Folie (9) der Form der Einheit (5) entsprechend vorgeformt ist.

8. Gehäuse nach einem oder mehreren der Ansprüche 1 bis 7, dadurch gekennzeichnet, daß die Folie (9) bzw. die Folie (9) mit der weiteren Folie (9) ein beutelförmiges Gebilde ist.

9. Gehäuse nach einem oder mehreren der Ansprüche 1 bis 7, dadurch gekennzeichnet, daß die Folie (9) bzw. Folien (9) ein Schlauch ist bzw. sind, in den die Einheit (5) einführbar ist, so daß der Schlauch wenigstens eine Umrandungsfläche der Querschnitte der Einheit (5) umschließt, die parallel zueinander sind.

10. Gehäuse nach einem oder mehreren der Ansprüche 1 bis 9, dadurch gekennzeichnet, daß die Einheit (5) an wenigstens 4 Seiten von dem fließfähigen Stoffsystem (7) umgeben ist.

11. Gehäuse nach einem oder mehreren der Ansprüche 1 bis 10, dadurch gekennzeichnet, daß das fließfähige Stoffsystem (7) eine derartige Viskosität aufweist, daß alleine aufgrund der Temperaturverhältnisse um die Einheit eine die Hitze abführende Wirkung des fließfähigen Stoffsystems (7) erhöhende Konvektion stattfindet.

12. Gehäuse nach Anspruch 11, dadurch gekennzeichnet, daß die Konvektion über einen Kreislauf erfolgt, der sich über den gesamten Querschnitt des zwischen Schlauch und Gehäuse (1, 2; 11, 12) befindlichen fließfähigen Stoffsystems (7) erstreckt.

13. Gehäuse nach einem oder mehreren der Ansprüche 1 bis 12, dadurch gekennzeichnet, daß die Folie (9) bzw. Folien (9) in einem Bereich von - 30 °C bis 120 °C ihre Eigenschaften im wesentlichen beibehalten.

14. Gehäuse nach einem oder mehreren der Ansprüche 1 bis 13, dadurch gekennzeichnet, daß Mittel vorgesehen sind, die ein Andrücken der Folie an wenigstens die warmen bzw. heißen Flächen (6) der Einheit (5) und/oder wenigstens eine Innenfläche des Gehäuses (1, 2; 11, 12) ermöglichen.

15. Gehäuse nach Anspruch 14, dadurch gekennzeichnet, daß die Mittel eine verschließbare Öffnung und/oder ein Ventil umfassen, durch die unter Druck bzw. Unterdruck im fließfähigen Stoffsystem (7) erzeugt wird.

16. Gehäuse nach Anspruch 14 und/oder 15, dadurch gekennzeichnet, daß die Mittel ein Druckmittel umfassen, mit dem eine Kraft auf wenigstens eine flexible Außenfläche des Gehäuses (1, 2; 11, 12) bzw. auf relativ zueinander bewegliche Teile des Gehäuse ausübbar ist.

17. Gehäuse nach einem oder mehreren der Ansprüche 1 bis 16, dadurch gekennzeichnet, daß das Gehäuse (1, 2; 11, 12) derart anzuordnen ist, daß die Seite der Einheit, die die warmen bzw. heißen Flächen (6) der Einheit (5) aufweist, im wesentlichen vertikal angeordnet ist.

18. Gehäuse nach Anspruch 17, dadurch gekennzeichnet, daß die Anordnung in einem Winkel bereich von - 30 °C bis 30 °C von der Vertikalen ist.

19. Gehäuse nach einem oder mehreren der Ansprüche 1 bis 18, dadurch gekennzeichnet, daß zur weiteren Verringerung der Schallemission das Gehäuse (1, 2; 11, 12,) mittels endlosen bzw. quasi endlosen und/oder länglichen Elastomeren befestigt ist.

20. Gehäuse nach einem oder mehreren der Ansprüche 1 bis 19, dadurch gekennzeichnet, daß die Gehäuseaußenfläche aus einem leitfähigen Material, insbesondere Metall, besteht und/oder daß die Oberfläche der Gehäuseaußenfläche im Vergleich zu einer flachen Fläche vergrößert ist.

21. Computer mit wenigstens einem für in den Computer angeordneten schall- und wärmeemittierenden Einheiten (5) vorgesehenen Gehäuse (1, 2; 11, 12) nach einem oder mehreren der Ansprüche 1 bis 19.
